# FASCICULE DE BREVET EUROPEEN

(11) **EP 0 456 556 B1**
(45) Date de publication et mention de la délivrance du brevet: **02.07.1997**
(21) Numéro de dépôt: 91401144.0
(22) Date de dépôt: 30.04.1991
(51) Int. Cl.: H01G 13/00, H01G 4/005, C23C 14/04

(54) **Dispositif de positionnement de bandes-cache dans une machine de métallisation**
Vorrichtung zum Positionieren eines Maskenbandes in einer Maschine zum Metallisieren
Apparatus for positioning a mask band in a metalization machine

(30) Priorité: 11.05.1990 FR 9005904
(43) Date de publication de la demande: 13.11.1991
(73) Titulaire: THOMSON-CSF PASSIVE COMPONENTS, 21850 Saint-Apollinaire (FR)
(72) Inventeur: Mounoussamy, André, F-92045 Paris la Défense (FR); Bouchard, Jean-Paul, F-92045 Paris la Défense (FR); Feral, Thierry, F-92045 Paris la Défense (FR)
(74) Mandataire: Guérin, Michel

(56) Documents cités:
- WO-A-87/00208
- DE-A- 2 744 147

## Description

La présente invention concerne un dispositif de positionnement de bandes-cache dans une machine de métallisation, notamment dans une machine de métallisation de film diélectrique de grande largeur permettant d'obtenir en sortie un film présentant des zones métallisées et des zones non métallisées.

Actuellement, pour fabriquer des condensateurs à film diélectrique métallisé de type empilé ou bobiné, on utilise des films plastiques présentant une zone métallisée et une marge latérale non métallisée. Ces films plastiques souples métallisés présentant une marge non métallisée sont obtenus en utilisant un procédé en deux étapes. Lors de la première étape, on métallise un film diélectrique souple de grande largeur tel qu'un film de polyester, de polycarbonate, de polysulfone, de polypropylène ou similaire par un procédé d'évaporation sous vide dans une machine de métallisation. La métallisation est réalisée en évaporant un métal tel que l'aluminium, le zinc, des alliages contenant de l'aluminium, du zinc, du chrome ou similaire. Les marges non métallisées sont obtenues durant le procédé d'évaporation sous vide, en prévoyant un ensemble de bandes-cache qui permet d'obtenir des parties non métallisées sur le film de grande largeur. Dans les machines le métallisation actuellement utilisées, le dispositif de positionnement des bandes-cache est constitué par plusieurs rouleaux à gorges sur lesquels sont entraînées les bandes-cache. Ce dispositif présente un certain nombre d'inconvénients. Il nécessite en effet d'avoir au moins un jeu de deux rouleaux, le plus souvent trois ou quatre, présentant des gorges de largeurs identiques. D'autre part, il est nécessaire d'avoir en réserve autant de jeux de rouleaux que de largeurs de bandes-cache. De plus, le positionnement des rouleaux à l'intérieur de la machine de métallisation est souvent long et complexe puisqu'il faut à chaque fois enlever plusieurs rouleaux et les remplacer lorsque l'on souhaite obtenir un film présentant des zones non métallisées de largeur différente.

La présente invention a donc pour but de remédier à ces inconvénients en proposant un nouveau dispositif de positionnement des bandes-cache dans une machine de métallisation de film de grande largeur.

En conséquence, la présente invention a pour objet un dispositif de positionnement d'au moins une bande-cache dans une machine de métallisation de film de grande largeur permettant d'obtenir en sortie un film présentant des zones métallisées et des zones non métallisées, caractérisé en ce qu'il est constitué par au moins deux rouleaux d'entraînement des bandes-cache présentant une surface lisse, les rouleaux d'entraînement étant positionnés pour amener les bandes- cache en face du film lors de la métallisation, et par au moins un peigne fixe de positionnement et de guidage desdites bandes.

De préférence, le peigne fixe est placé en amont de la partie de la métallisation proprement dite. Ceci permet de positionner très précisément les bandes-cache de manière à obtenir après métallisation et découpe un film plastique métallisé dont les largeurs sont constantes dans des tolérances très serrées.

De préférence, selon une autre caractéristique de la présente invention, le dispositif de positionnement comporte de plus un peigne de pré-guidage qui permet de parfaire le positionnement des bandes-cache.

Selon une caractéristique supplémentaire de la présente invention, chaque peigne est muni d'une rangée de dents, les encoches entre chaque dent présentant une largeur identique à la largeur des bandes-cache de manière à obtenir des zones non métallisées présentant des largeurs stables.

Selon encore une autre caractéristique, chaque peigne est muni de deux rangées de dents positionnées symétriquement l'une par rapport à l'autre, les encoches le chaque rangée présentant des largeurs différentes pour s'adapter à des films présentant des zones métallisées et non métallisées de largeurs différentes ou de pas différents. Cette caractéristique permet de limiter le nombre de peignes en stock et de faciliter leur mise en place.

Selon un mode de réalisation préférentiel, chaque peigne est réalisé en un matériau stable aux températures et/ou aux pressions régnant dans la machine de métallisation. De préférence, chaque peigne est réalisé en acier INVAR®.

L'utilisation d'un tel matériau permet d'obtenir des peignes qui ne donnent pas de variations dimmensionnelles avec la température et dans une atmosphère sous vide (10⁻² à 10⁻³Pascal) telles que celles règnant dans la machine de métallisation habituellement utilisée.

D'autres caractéristiques et avantages de la présente invention apparaitront à la lecture d'un mode de réalisation préférentiel mais non limitatif, faite avec référence aux dessins ci-annexés dans lesquels :
- la figure 1 est une vue en perspective schématique d'un peigne conforme à la présente invention ;
- la figure 2 est une vue en plan schématique d'un autre mode de réalisation d'un peigne conforme à la présente invention, et
- la figure 3 est un schéma montrant le positionnement du peigne dans une machine de métallisation de films de grande largeur de type connu.

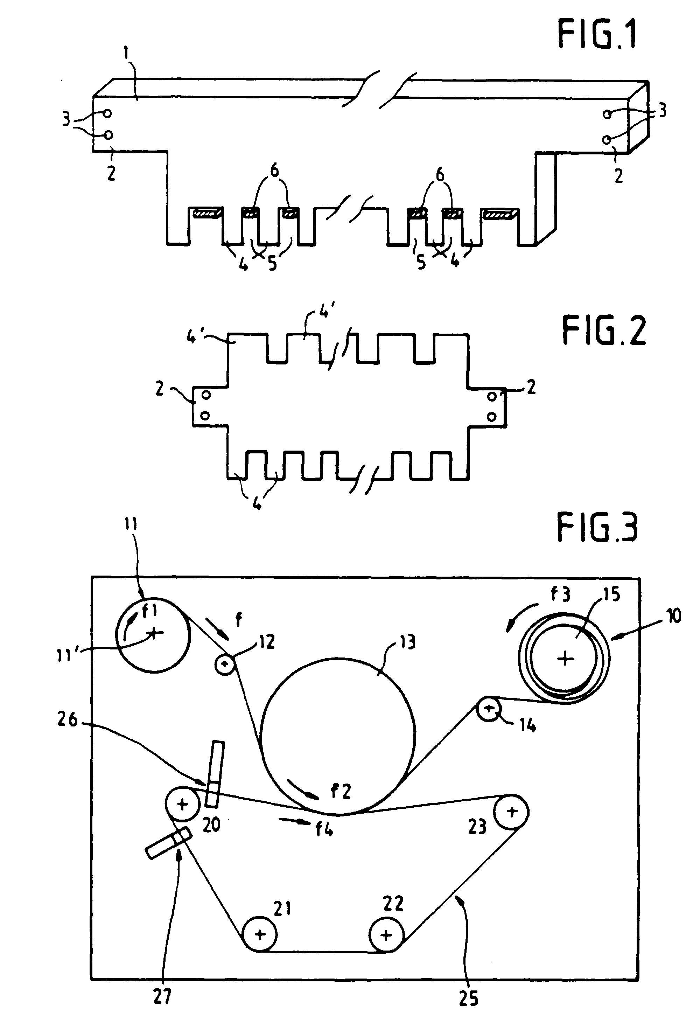

Sur la figure 1, on a représenté une vue en perspective schématique d'un mode de réalisation d'un peigne conforme à la présente invention. Ce peigne comporte deux bras de fixation 2 munis chacun de deux trous 3 pour le passage de moyens de fixation sur des bras-support ou autres, telles que des tiges filetées. Comme représenté sur la figure 1, la partie centrale du peigne 1 est munie sur un de ses côtés de dents 4 présentant une largeur définie 1, ces dents étant chacune séparées par des encoches 5 dans lesquelles sont passées des bandes-cache telles que représentées en coupe par la référence 6. Dans ce cas, les encoches 5 présentent une largeur 1' sensiblement identique à la largeur des bandes-cache 6. Cette largeur est égale à deux fois la marge non métallisée, dans le cas où les films obtenus en utilisant le peigne sont utilisés pour réaliser des condensateurs à film plastique métallisé et notamment des condensateurs de type chips. Dans ce cas, la largeur 1' des encoches, à savoir la largeur des bandes, peut être de l'ordre de 0,5 mm.

Selon une variante de réalisation représentée à la figure 2, le peigne peut présenter des dents 4 et 4' de chaque côté de la partie centrale prolongeant les bras 2. Dans ce cas, les dents et les encoches, réalisées de chaque côté, présentent des largeurs différentes de manière à pouvoir être utilisées pour la réalisation de films métallisés présentant des zones métallisées et des zones non métallisées ayant des dimensions différentes selon leur utilisation finale. Les dents et les encoches peuvent aussi présenter un pas différent. Ceci permet de limiter le nombre de peignes que l'on doit stocker en fonction des produits finaux que l'on désire fabriquer.

Les peignes décrits ci-dessus sont utilisés dans une machine de métallisation sous vide. Ils sont donc réalisés en un matériau qui ne se déforme pas aux températures et aux pressions régnant dans les machines ( 10⁻² - 10⁻³Pascal). De préférence, ils sont réalisés en acier " INVAR".

On décrira maintenant succinctement avec référence à la figure 3, un mode de réalisation d'une machine de métallisation sous vide munie d'un dispositif de positionnement de bandes-cache utilisant au moins un peigne conforme à la présente invention. Comme représenté sur la figure 3, dans une enceinte sous vide 10, on trouve schématiquement une première bobine 11 appelée bobine-mère montée sur un mandrin symbolisé par la référence 11'. Cette bobine-mère est constituée par un film diélectrique nu tel qu'un film de polyester, de polycarbonate, de polysulfone, de polypropylène ou similaire. Ce film est un film de grande largeur et peut présenter par exemple une largeur de 515 mm. Comme représenté sur la figure 3, le film issu de la bobine-mère 11 est déroulé selon la flèche f et est entraîné par un galet 12 vers une roue 13 maintenue à une température de -30°C contre laquelle a lieu la métallisation par évaporation sous vide. Puis le film maintenu tendu par l'intermédiaire du galet 14 est enroulé sur une roue 15 sur laquelle il est stocké pour les opérations de traitement ultérieures. Comme représenté sur la figure 3, les différentes bobines et roues 11, 13, 15 sont entraînées en rotation selon le sens indiqué par les flèches f1, f2, f3.

Conformément à la présente invention, la machine de métallisation 10 décrite ci-dessus est munie d'un dispositif de positionnement de bandes-cache permettant d'obtenir en sortie un film métallisé présentant des zones métallisées et des zones non métallisées. Le dispositif de positionnement des bandes-cache est constitué, dans le mode de réalisation représenté, par quatre rouleaux 20, 21, 22, 23 de guidage et d'entraînement des bandes-cache. Une bande 25 a été représentée sur la figure 3. Cette bande est entraînée selon la flèche f4. Elle est réalisée, de préférence en une matière plastique, telle que la matière plastique vendue sous la marque KAPTON®. Conformément à la présente invention, les rouleaux 20, 21, 22, 23 sont des rouleaux présentant une surface lisse à l'inverse des rouleaux antérieurement utilisés qui présentaient chacun des gorges de guidage. De ce fait, les rouleaux 20, 21, 22, 23 sont fixés à demeure dans la machine de métallisation. D'autre part, conformément à la présente invention, le dispositif de positionnement comporte deux peignes 26, 27 permettant de réaliser respectivement le guidage et le pré-guidage des différentes bandes-cache 25. Ces peignes ont la forme décrite soit à la figure 1, soit à la figure 2. En fait, le peigne 27 positionné juste avant le rouleau 20, à savoir le rouleau se trouvant en amont de la zone où les bandes-cache viennent au contact du film à métalliser au niveau de l'emplacement de métallisation, est un peigne de pré-guidage permettant un premier positionnement approximatif des bandes-cache. Le peigne 26 positionné juste après le rouleau 20, à savoir juste avant l'emplacement de la métallisation, est un peigne de guidage qui permet un positionnement exact des bandes-cache par rapport au film à métalliser issu de la bobine 11. L'utilisation d'un tel dispositif de guidage pour les bandes-cache présente un certain nombre d'avantages qui ont été mentionnés dans l'introduction de la présente demande. Notamment, lorsque l'on veut métalliser un nouveau film avec une largeur de zones métallisées et non métalisées différente, il n'est nécessaire de modifier que les peignes de guidage puisque les rouleaux d'entraînement des bandes-cache 20, 21, 22, 23 sont des rouleaux à surface lisse. Ceci permet une mise en oeuvre de la machine beaucoup plus rapide qu'avec le dispositif actuel. D'autre part, l'utilisation d'un peigne de guidage 26 permet un positionnement très précis des bandes-cache, ce qui entraîne l'obtention après métallisation et découpe lors d'une étape ultérieure, d'un film plastique métallisé dont les largeurs sont constantes dans des tolérances très serrées. A titre d'exemple, ceci permet de réaliser des films plastiques métallisés utilisés dans des condensateurs chips présentant une largeur de film de 2,5 mm et une largeur de marge de 0, 25 mm.

D'autre part, l'utilisation d'un peigne tel que décrit ci-dessus permet de métalliser un film de grande largeur en utilisant un nombre de bandes-cache guidées qui peut être aussi grand que nécessaire. Il est possible de réaliser des peignes permettant un guidage de plus de 100 bandes-cache.

Il est évident pour l'homne de l'art que différentes modifications peuvent être apportées au dispositif de positionnement des bandes-cache décrit avec référence à la figure 3, notamment en ce qui concerne le nombre de rouleaux lisses utilisés pour l'entraînement des bandes-cache qui doit être au moins égal à deux et en ce qui concerne le nombre de peignes qui doit être au moins égal à un.

## Revendications

1. Dispositif de positionnement d'au moins une bande-cache (25) dans une machine de métallisation de film de grande largeur permettant d'obtenir en sortie un film présentant des zones métallisées et des zones non métallisées, caractérisé en ce qu'il est constitué par au moins deux rouleaux (20, 21, 22, 23) d'entraînement des bandes-cache présentant une surface lisse, les rouleaux d'entraînement étant positionnés pour amener les bandes-cache en face du film lors de la métallisation, et par au moins un peigne (26) fixe de positionnement et de guidage desdites bandes.

2. Dispositif selon la revendication 1, caractérisé en ce que le peigne (26) fixe est placé en amont de l'endroit de la métallisation.

3. Dispositif selon l'une quelconque des revendications 1 et 2, caractérisé en ce qu'il comporte de plus un peigne de pré-guidage (27).

4. Dispositif selon l'une quelconque des revendications 1 à 3, caractérisé en ce que chaque peigne (1) est muni d'une rangée de dents (4), les encoches (5) entre chaque dent présentant une largeur (1') identique à la largeur des bandes-cache (6).

5. Dispositif selon l'une quelconque des revendications 1 à 3, caractérisé en ce que chaque peigne est muni de deux rangées de dents (4, 4') positionnées symétriquement l'une par rapport à l'autre, les encoches de chaque rangée présentant des largeurs différentes pour s'adapter à des films présentant des zones métallisées et non-métallisées de largeurs différentes ou de pas différents.

6. Dispositif selon l'une quelconque des revendications 1 à 5, caractérisé en ce que chaque peigne est réalisé en un matériau stable aux températures et/ou aux pressions régnant dans la machine de métallisation.

7. Dispositif selon la revendication 6, caractérisé en ce que chaque peigne est réalisé en acier INVAR®.

## Patentansprüche

1. Vorrichtung zur Positionierung von mindestens einem Maskenband (25) in einer Maschine zu Metallbeschichtung von Folien großer Breite, die eine Folie mit metallbeschichteten und nicht-metallbeschichteten Zonen ergibt, dadurch gekennzeichnet, daß sie aus mindestens zwei Antriebsrollen mit glatter Oberfläche (20, 21, 22, 23) für die Maskenbänder, wobei die Antriebsrollen so positioniert werden, daß die Maskenbänder bei der Metallbeschichtung vor die Folie gelangen, und aus mindestens einem festen Kamm (26) zur Positionierung und Führung dieser Bänder besteht.

2. Vorrichtung nach Anspruch 1, dadurch gekennzeichnet, daß der feste Kamm (26) vor dem eigentlichen Metallbeschichtungsbereich angeordnet ist.

3. Vorrichtung nach einem beliebigen der Ansprüche 1 und 2, dadurch gekennzeichnet, daß sie außerdem einen Vor-Führungskamm (27) aufweist.

4. Vorrichtung nach einem beliebigen der Ansprüche 1 bis 3, dadurch gekennzeichnet, daß jeder Kamm (1) mit einer Reihe von Zinken (4) versehen ist, wobei die Kerben (5) zwischen den Zinken eine Breite (1') aufweisen, die der Breite der Maskenbänder (6) gleicht.

5. Vorrichtung nach einem beliebigen der Ansprüche 1 bis 3, dadurch gekennzeichnet, daß jeder Kamm mit zwei Reihen von Zinken (4, 4') versehen ist, die zueinander symmetrisch angeordnet sind, wobei die Kerben jeder Reihe unterschiedliche Breiten aufweisen, um sich Folien anzupassen, die metallbeschichtete Zonen und nicht-metallbeschichtete Zonen unterschiedlicher Breite oder unterschiedlichen Abstands aufweisen.

6. Vorrichtung nach einem beliebigen der Ansprüche 1 bis 5, dadurch gekennzeichnet, daß jeder Kamm aus einem Material besteht, das die in der Metallbeschichtungsmaschine herrschenden Temperaturen und/oder Drücke aushält.

7. Vorrichtung nach Anspruch 6, dadurch gekennzeichnet, daß jeder Kamm aus INVAR^{R}-Stahl hergestellt wird.

## Claims

1. Device for the positioning of at least one masking band (25) in a machine for the metallization of large-width film, making it possible to obtain at the outlet a film which has metallized zones and nonmetallized zones, characterized in that it consists of at least two masking-band drive rollers (20, 21, 22, 23) having a smooth surface, the drive rollers being positioned so as to bring the masking bands opposite the film during metallization, and of at least one fixed comb (26) for positioning and guiding the said bands.

2. Device according to Claim 1, characterized in that the fixed comb (26) is located upstream of the metallization point.

3. Device according to either one of Claims 1 and 2, characterized in that it comprises, furthermore, a preguiding comb (27).

4. Device according to any one of Claims 1 to 3, characterized in that each comb (1) is equipped with a row of teeth (4), the notches (5) between each tooth having a width (1') identical to the width of the masking bands (6).

5. Device according to any one of Claims 1 to 3, characterized in that each comb is equipped with two rows of teeth (4, 4'), which rows are positioned symmetrically relative to one another, the notches of each row having different widths so as to adapt to films having metallized and nonmetallized zones of different widths or of different spacings.

6. Device according to any one of Claims 1 to 5, characterized in that each comb is produced from a material which is stable under the temperatures and/or pressures prevailing in the metallization machine.

7. Device according to Claim 6, characterized in that each comb is produced from INVAR® steel.
